# EUROPÄISCHE PATENTSCHRIFT

(11) **EP 4 336 537 B1**
(45) Veröffentlichungstag und Bekanntmachung des Hinweises auf die Patenterteilung: **01.07.2026**
(21) Anmeldenummer: 23187603.8
(22) Anmeldetag: 25.07.2023
(51) Int. Cl.: H01H 47/00, H01H 51/20

(54) **RELAISVORRICHTUNG UND SICHERHEITSSCHALTGERÄT MIT MINDESTENS EINER RELAISVORRICHTUNG**
RELAY DEVICE AND SAFETY SWITCHING DEVICE HAVING AT LEAST ONE RELAY DEVICE
DISPOSITIF RELAIS ET APPAREIL DE COMMUTATION DE SÉCURITÉ DOTÉ D'AU MOINS UN DISPOSITIF RELAIS

(30) Priorität: 06.09.2022 DE 102022122527
(43) Veröffentlichungstag der Anmeldung: 13.03.2024
(73) Patentinhaber: Pilz GmbH & Co. KG, 73760 Ostfildern (DE)
(72) Erfinder: Bauknecht, Jochen, 73760 Ostfildern (DE); Rotzinger, Florian, 73760 Ostfildern (DE)
(74) Vertreter: Manske, Jörg

(56) Entgegenhaltungen:
- EP-A2- 0 213 064
- DE-A1- 102004 033 359
- DE-A1- 102015 104 211
- DE-A1- 4 409 541

## Beschreibung

Die vorliegende Erfindung betrifft eine Relaisvorrichtung. Darüber hinaus betrifft die vorliegende Erfindung ein Sicherheitsschaltgerät nach dem Oberbegriff des Anspruchs 8.

Relaisvorrichtungen sind aus dem Stand der Technik in unterschiedlichen Ausführungsformen bereits bekannt. Ein Anwendungsgebiet derartiger Relaisvorrichtungen sind insbesondere Sicherheitsschaltgeräte, mittels derer zumindest eine an diese angeschlossene elektrische Last beziehungsweise ein an diese angeschlossener Verbraucher fehlersicher abgeschaltet werden kann. Derartige Sicherheitsschaltgeräte werden typischerweise eingesetzt, um eine automatisiert arbeitende technische Anlage, von der im Betrieb eine Gefahr für Leib und Leben von Menschen ausgehen kann, fehlersicher abzuschalten oder anderweitig in einen ungefährlichen Anlagenzustand zu überführen. Fehlersicher bedeutet in diesem Zusammenhang, dass das Abschalten der gefahrbringenden Anlage selbst dann gewährleistet sein muss, wenn in den sicherheitsrelevanten Komponenten der Anlage einschließlich des Sicherheitsschaltgeräts ein Fehler auftritt, beispielsweise aufgrund des Ausfalls eines Bauteils oder der Beschädigung eines Kabels. Sicherheitsschaltgeräte unterliegen daher besonderen Anforderungen, die insbesondere in den einschlägigen Normen zur Maschinensicherheit, wie zum Beispiel ISO 13849, IEC 61508 u.a., definiert sind. Da diese Normen abhängig vom Gefährdungsgrad unterschiedliche Anforderungen definieren, sollen Sicherheitsschaltgeräte im Sinne der vorliegenden Erfindung im Folgenden vor allem solche Geräte sein, die eine Ein-FehlerSicherheit im Sinne von SIL3 gemäß IEC 61508 und/oder PLe gemäß ISO 13849 beim sicheren Abschalten einer elektrisch betriebenen Maschine gewährleisten.

Typische Anwendungsfälle sind das Abschalten einer automatisiert arbeitenden Maschine als Reaktion auf die Betätigung eines Not-Aus-Tasters und/oder beim Öffnen einer Schutztür. Aus funktionaler Sicht bilden Not-Aus-Taster und Schutztüren Signalgeber, deren Signale von dem Sicherheitsschaltgerät verarbeitet und ausgewertet werden. Weitere Signalgeber können zum Beispiel Lichtschranken, Lichtgitter und dergleichen oder Überwachungsschaltungen sein, die eine Prozessgröße, wie etwa eine Drehzahl, einen elektrischen Strom, eine elektrische Spannung u.a. auf Einhaltung vorgegebener Grenzwerte überwachen.

Das Sicherheitsschaltgerät dient dazu, das vom Signalgeber erzeugte Signal, welches ein Eingangssignal aus Sicht des Sicherheitsschaltgeräts bildet, fehlersicher auszuwerten und in Abhängigkeit davon ein Abschaltsignal zum fehlersicheren Abschalten zumindest einer elektrischen Last oder eines Verbrauchers zu erzeugen. Gattungsgemäße Sicherheitsschaltgeräte sind daher in aller Regel mehrkanalig-redundant aufgebaut und führen zudem regelmäßige interne und/oder externe Funktionstests durch, die die erforderliche Fehlersicherheit gewährleisten. In zahlreichen Ländern benötigen Sicherheitsschaltgeräte im Sinne der vorliegenden Erfindung eine entsprechende Zertifizierung durch eine zugelassene Prüfbehörde, wie etwa durch den TÜV oder die Berufsgenossenschaften in Deutschland, die die Einhaltung der sicherheitstechnischen Konstruktionsprinzipien bescheinigt.

Die DE 44 09 541 A1 offenbart eine sicherheitstechnische Einrichtung für eine Maschine und/oder eine Anlage, die zumindest eine in einem Steuerstromkreis liegende Einschaltvorrichtung, eine Ausschaltvorrichtung, eine Not-Ausschaltvorrichtung sowie mindestens zwei, vorzugsweise drei, Hilfsschütze aufweist. Die Hilfsschütze weisen derart einander zugeordnete Kontakte auf, die in dem Steuerstromkreis und in wenigstens einem Hauptstromkreis liegen und als Schalter (insbesondere Öffner beziehungsweise Schließer) ausgebildet sind. Bei einer Betätigung der Not-Ausschaltvorrichtung wird wenigstens ein Hilfsschütz in dem Steuerstromkreis abgeschaltet. Daraus resultiert, dass wenigstens ein in dem Hauptstromkreis liegender Kontakt zur Vermeidung einer Gefahrensituation betätigt wird. Einem der Hilfsschütze ist eine Auswertevorrichtung zugeordnet, die zumindest eine Sensorvorrichtung aufweist, wobei resultierend aus einer Betätigung der Sensorvorrichtung der in dem Hauptstromkreis liegende Kontakt und/oder ein in einem weiteren Hauptstromkreis liegender Kontakt zur Vermeidung der Gefahrensituation betätigt, insbesondere geöffnet, wird.

Die EP 0 213 064 A2 offenbart ein Relais zum zwei- oder mehrpoligen Abschalten von Verbrauchern mit einem gemeinsamen Antrieb, bei dem mindestens zwei Kontaktfedersätze in Öffnungsrichtung mechanisch derart entkoppelt sind, dass beim Nichtöffnen eines Kontakts der mindestens eine andere Kontakt ungehindert öffnet. Zur Druckkraftübertragung zwischen einem Anker und jeweils einem Kontaktfedersatz ist ein mechanisches Zwischenglied vorgesehen. Die Zwischenglieder treten mit einem quer zu deren Verschieberichtung beweglichen Verriegelungselement derart in Wechselwirkung, dass die Verschiebung des zugeordneten Zwischenglieds gesperrt ist, wenn das mindestens eine andere Zwischenglied aus seiner der Ankerruhestellung entsprechenden Position heraus verschoben ist, und die Sperrung nicht eintritt, wenn die Zwischenglieder im Wesentlichen gleichförmig aus der genannten Position heraus verschoben werden.

Ein aus der DE 10 2015 104 211 A1 bekanntes Sicherheitsschaltgerät zum fehlersicheren Abschalten einer elektrischen Last besitzt einen Eingangsteil zum Aufnehmen von zumindest einem sicherheitsrelevanten Eingangssignal, einen Logikteil zum Verarbeiten des zumindest einen sicherheitsrelevanten Eingangssignals und einen Ausgangsteil, der eine Relaisspule und einen ersten Relaiskontakt, einen zweiten Relaiskontakt, einen dritten Relaiskontakt und einen vierten Relaiskontakt aufweist. Der erste und der zweite Relaiskontakt sind elektrisch in Reihe zueinander angeordnet. Der dritte und der vierte Relaiskontakt sind ebenfalls elektrisch in Reihe zueinander angeordnet. Der erste und der dritte Relaiskontakt sind mechanisch miteinander gekoppelt, um eine erste Gruppe von zwangsgeführten Relaiskontakten zu bilden. Ebenso sind der zweite und vierte Relaiskontakt mechanisch miteinander gekoppelt, um eine zweite Gruppe von zwangsgeführten Relaiskontakten zu bilden. Der Logikteil steuert die erste Gruppe und die zweite Gruppe redundant an, um in Abhängigkeit von dem zumindest einen sicherheitsrelevanten Eingangssignal wahlweise einen Stromfluss zu der elektrischen Last zu ermöglichen oder fehlersicher zu unterbrechen. Die Relaisspule ist mit der ersten Gruppe und der zweiten Gruppe von zwangsgeführten Relaiskontakten elektromagnetisch gekoppelt, so dass der Logikteil die Relaiskontakte über die eine Relaisspule gemeinsam ansteuern kann. Mechanisch können sich die Relaiskontakte der ersten Gruppe jedoch separat von den Relaiskontakten der zweiten Gruppe bewegen.

Aus der DE 10 2004 033 359 A1 ist eine Vorrichtung zum fehlersicheren Abschalten eines elektrischen Verbrauchers, insbesondere einer elektrisch angetriebenen Maschine bekannt. Diese Vorrichtung weist ein Sicherheitsschaltgerät sowie eine Relaisvorrichtung auf. Das Sicherheitsschaltgerät ist dazu ausgebildet, zwei externe Schaltelemente, die räumlich entfernt vom Sicherheitsschaltgerät angeordnet sind, zeitlich versetzt zueinander von einem elektrisch leitenden in einen sperrenden Zustand (und umgekehrt) zu schalten. Die Relaisvorrichtung weist ein erstes Relais mit einer Anzahl n = 3 zwangsgeführter und parallel zueinander angeordneter Schließerkontakte auf, die mittels eines gemeinsamen Ankers von der Öffnungsstellung in die Schließstellung (und umgekehrt) bewegbar sind. Ferner weist die Relaisvorrichtung ein zweites Relais mit einer Anzahl m = n= 3 zwangsgeführter Schließerkontakte auf, die mittels eines gemeinsamen Ankers von der Öffnungsstellung in die Schließstellung (und umgekehrt) bewegbar sind. Zwei der Schließerkontakte des zweiten Relais sind in klassischer Schaltungstechnik elektrisch in Reihe mit zwei der Schließerkontakte des ersten Relais angeordnet. Die Relaisvorrichtung stellt zwei parallele Schaltpfade zur Verfügung, mittels derer die Schaltkontakte der Relais getrennt voneinander an Ausgangsanschlüssen herausgeführt sind, wobei die beiden Schaltpfade zeitlich versetzt zueinander geschaltet werden können, so dass zum Beispiel zumindest zwei externe elektrische Schaltelemente (elektrische Lasten) zeitlich versetzt zueinander von einem elektrisch leitenden (geschlossenen) Zustand in einen sperrenden (geöffneten) Zustand geschaltet werden können. Es ist mittels dieser aus dem Stand der Technik bekannten Relaisvorrichtung auch möglich, zwei verschiedene Teile einer Maschine oder technischen Anlage zeitversetzt zu schalten. Beispielsweise kann zunächst eine Steuerungseinrichtung eingeschaltet werden und zeitlich versetzt dazu ein Roboter aktiviert werden.

Diese aus dem Stand der Technik vorbekannte Relaisvorrichtung sowie das damit ausgestattete Sicherheitsschaltgerät haben den Nachteil, dass diejenigen Schaltpfade, die nur mit einem Relais ausgestattet sind, nicht sicher sind.

Die vorliegende Erfindung macht es sich zur Aufgabe, eine Relaisvorrichtung sowie ein Sicherheitsschaltgerät zur Verfügung zu stellen, die kompakt und kostengünstig ausgeführt sind und bei denen alle Schaltpfade sicher sind.

Die Lösung dieser Aufgabe liefern eine Relaisvorrichtung mit den Merkmalen des Anspruchs 1 sowie ein gattungsgemäßes Sicherheitsschaltgerät mit den Merkmalen des kennzeichnenden Teils des Anspruchs 8. Die Unteransprüche betreffen vorteilhafte Weiterbildungen der Erfindung.

Die Erfindung stellt eine Relaisvorrichtung zur Verfügung, umfassend
- eine Anzahl von Eingangsanschlüssen,
- eine Anzahl von Ausgangsanschlüssen,
- ein erstes Relais mit einer Anzahl n ≥ 2 zwangsgeführter und parallel zueinander angeordneter Schließerkontakte, die eine erste Schließerkontaktgruppe bilden und mittels eines ersten gemeinsamen Ankers von einer Öffnungsstellung in eine Schließstellung und umgekehrt bewegbar sind,
- ein zweites Relais mit einer Anzahl m < n zwangsgeführter und parallel zueinander angeordneter Schließerkontakte, die mittels eines gemeinsamen Ankers von einer Öffnungsstellung in eine Schließstellung und umgekehrt bewegbar sind,
wobei das erste Relais und das zweite Relais elektrisch in Reihe zueinander zwischen den Eingangsanschlüssen und den Ausgangsanschlüssen angeordnet sind, so dass die Relaisvorrichtung mehrere parallele Schaltpfade aufweist, und wobei in einer Anzahl von Schaltpfaden, die der Anzahl m der Schließerkontakte des zweiten Relais entspricht, jeweils ein Schließerkontakt des ersten Relais und ein Schließerkontakt des zweiten Relais elektrisch in Reihe angeordnet sind, wobei das erste Relais als Doppelankerrelais ausgebildet ist und eine der Anzahl der Schließerkontakte der ersten Schließerkontaktgruppe entsprechende Anzahl zwangsgeführter und parallel zueinander angeordneter Schließerkontakte aufweist, die eine zweite Schließerkontaktgruppe bilden und mittels eines zweiten gemeinsamen Ankers von einer Öffnungsstellung in eine Schließstellung und umgekehrt bewegbar sind, wobei die Schließerkontakte der ersten Schließerkontaktgruppe und die Schließerkontakte der zweiten Schließerkontaktgruppe paarweise elektrisch in Reihe angeordnet sind.

Durch die Ausführung des ersten Relais als Doppelankerrelais mit den vorstehend genannten Merkmalen ergeben sich unter anderem Sicherheitsvorteile. Denn alle bewegbaren Teile des als Doppelankerrelais ausgeführten ersten Relais, insbesondere die Schließerkontakte, sind doppelt ausgeführt. Durch diese Redundanz wird die Betriebssicherheit des ersten Relais im Vergleich zum Stand der Technik erheblich erhöht. Darüber hinaus benötigt ein Doppelankerrelais weniger Platz und ist kostengünstiger als zwei separate, elektrisch in Reihe angeordnete Relais. Der externe Verdrahtungsaufwand ist bei einem Doppelankerrelais geringer, da weniger elektrische Schaltkontakte miteinander zu verdrahten sind. Überdies benötigt ein Doppelankerrelais weniger Bauraum, da die technischen Funktionen zweier elektrisch in Reihe zueinander angeordneter Relais in einem Bauteil realisiert sind. Das erste Relais und das zweite Relais können in vorteilhafter Weise so angesteuert werden, dass eine Einschaltverzögerung und eine Ausschaltverzögerung für mehrere elektrische Lasten oder Verbraucher, die an die Relaisvorrichtung angeschlossen sind, auf einfache Weise realisiert werden können.

In einer vorteilhaften Ausführungsform wird vorgeschlagen, dass die Relaisvorrichtung eine erste Relaisspule, die mit dem ersten Anker des ersten Relais elektromagnetisch gekoppelt ist, und eine zweite Relaisspule, die mit dem zweiten Anker des ersten Relais elektromagnetisch gekoppelt ist, aufweist. In dieser Ausführungsform ist also jedem der beiden Anker des Doppelankerrelais jeweils eine Relaisspule zugeordnet, mittels derer aufgrund der elektromagnetischen Kopplung jeweils eine Schiebebewegung des zugehörigen Ankers initiiert werden kann.

In einer besonders vorteilhaften Ausführungsform kann vorgesehen sein, dass die Relaisvorrichtung eine Relaisspule, die mit dem ersten Anker des ersten Relais und mit dem zweiten Anker des ersten Relais elektromagnetisch gekoppelt ist, aufweist. Da in dieser Ausführungsform nur eine einzige Relaisspule vorgesehen ist, die beiden Ankern des Doppelankerrelais zugeordnet ist, ergeben sich durch den Verzicht auf eine zusätzliche Relaisspule sowohl Bauraumvorteile als auch Kostenvorteile. Die Relaisvorrichtung kann somit insgesamt kompakter ausgeführt werden.

In einer Ausführungsform besteht die Möglichkeit, dass die Relaisvorrichtung eine Anzahl von Eingangsanschlüssen aufweist, die kleiner als die Anzahl der Ausgangsanschlüsse ist. Wenigstens ein Eingangsanschluss teilt sich in dieser Ausführungsform zumindest zwei Ausgangsanschlüsse.

In einer bevorzugten Ausführungsform wird vorgeschlagen, dass das erste Relais einen ersten zwangsgeführten Öffnerkontakt, der dazu ausgebildet ist, die Schaltstellungen der Schließerkontakte der ersten Schließerkontaktgruppe zu erfassen, und einen zweiten zwangsgeführten Öffnerkontakt, der dazu ausgebildet ist, die Schaltstellungen der Schließerkontakte der zweiten Schließerkontaktgruppe zu erfassen, aufweist. Dadurch können die Schaltstellungen der Schließerkontakte des ersten Relais sehr einfach überprüft und mögliche Fehler, wie zum Beispiel Verklebungen der Schließerkontakte, sehr einfach erfasst werden.

Vorzugsweise können die Öffnerkontakte des ersten Relais elektrisch in Reihe angeordnet sein.

In einer weiteren vorteilhaften Ausführungsform besteht die Möglichkeit, dass das zweite Relais einen zwangsgeführten Öffnerkontakt umfasst, der dazu ausgebildet ist, die Schaltstellungen der Schließerkontakte des zweiten Relais zu erfassen. Dadurch können die Schaltstellungen der Schließerkontakte des zweiten Relais sehr einfach überprüft und mögliche Fehler, wie zum Beispiel Verklebungen der Schließerkontakte, erfasst werden.

Ein erfindungsgemäßes Sicherheitsschaltgerät zeichnet sich gemäß Anspruch 8 dadurch aus, dass die Relaisvorrichtung nach einem der Ansprüche 1 bis 7 ausgeführt ist und dass die Auswerte- und Steuereinrichtung dazu eingerichtet ist, das erste Relais und das zweite Relais zeitlich versetzt zueinander anzusteuern.

Dadurch wird ein Sicherheitsschaltgerät zur Verfügung gestellt, welches eine Einschalt- und Ausschaltverzögerung für mehrere elektrische Lasten zur Verfügung stellt und das aufgrund der Verwendung der erfindungsgemäßen Relaisvorrichtung, bei der das erste Relais als Doppelankerrelais ausgebildet ist, im Vergleich zum Stand der Technik verbesserte Sicherheitseigenschaften aufweist.

Es soll an dieser Stelle betont werden, dass das Einsatzgebiet der erfindungsgemäßen Relaisvorrichtung nicht auf das erfindungsgemäße Sicherheitsschaltgerät beschränkt ist. Die erfindungsgemäße Relaisvorrichtung kann überall dort eingesetzt werden, wo aus technischer Sicht das Erfordernis besteht, Einschaltverzögerungen und/oder Ausschaltverzögerungen für mehrere elektrische Lasten oder Verbraucher zur Verfügung zu stellen.

Es ist mittels der hier vorgestellten Relaisvorrichtung auch möglich, zwei verschiedene Teile einer Maschine oder technischen Anlage zeitversetzt zu schalten. Beispielsweise kann zunächst eine Steuerungseinrichtung eingeschaltet werden und zeitlich versetzt dazu ein Roboter aktiviert werden. Die Steuerungseinrichtung und der Roboter bilden dann zwei Verbraucher im Sinne der vorliegenden Erfindung.

Weitere Merkmale und Vorteile von Ausführungsbeispielen der Erfindung werden unter Bezugnahme auf die Zeichnungen nachfolgend beschrieben. Dabei werden für gleiche oder ähnliche Teile und für Teile mit gleichen oder ähnlichen Funktionen dieselben Bezugszeichen verwendet. Es zeigen:
- Fig. 1: eine schematische Darstellung einer technischen Anlage, die mit einem Sicherheitsschaltgerät ausgestattet ist, welches gemäß einem Ausführungsbeispiel der vorliegenden Erfindung ausgeführt ist,
- Fig. 2: ein Sicherheitsschaltgerät mit einer Relaisvorrichtung, die gemäß einem ersten Ausführungsbeispiel der vorliegenden Erfindung ausgeführt ist,
- Fig. 3: ein Sicherheitsschaltgerät mit einer Relaisvorrichtung, die gemäß einem zweiten Ausführungsbeispiel der vorliegenden Erfindung ausgeführt ist.

Es ist nicht notwendig, dass ein erfindungsgemäßes Sicherheitsschaltgerät 100 und eine erfindungsgemäße Relaisvorrichtung 1 alle nachfolgend beschriebenen Merkmale aufweisen. Es ist auch möglich, dass ein erfindungsgemäßes Sicherheitsschaltgerät 100 und eine erfindungsgemäße Relaisvorrichtung 1 nur einzelne Merkmale der nachfolgend beschriebenen Ausführungsbeispiele aufweisen.

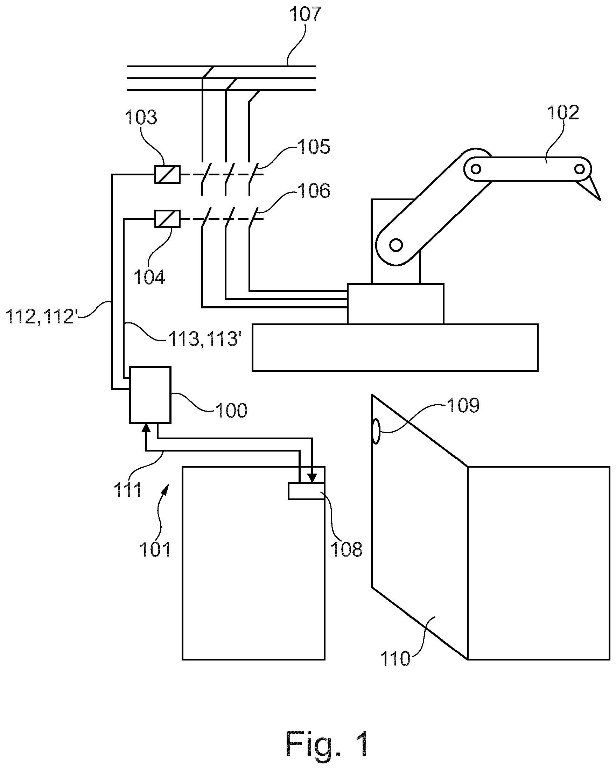

In Fig. 1 ist eine technische Anlage 101 gezeigt, die in diesem Ausführungsbeispiel einen automatisiert arbeitenden Roboter 102 umfasst. Während des Betriebs führt der Roboter 102 Bewegungen aus, die Menschen im Gefahrenbereich des Roboters 102 gefährden können. Um einen sicheren Betrieb des Roboters 102 zu gewährleisten, weist die technische Anlage 101 ein Sicherheitsschaltgerät 100 auf. Das Sicherheitsschaltgerät 100 ist allgemein zum fehlersicheren Abschalten mehrerer elektrischer Lasten oder Verbraucher ausgebildet. Die elektrischen Lasten, welche in der technischen Anlage 101 zum Einsatz kommen, können zum Beispiel elektrische Antriebe, Schütze 103, 104 oder Ventile, insbesondere Magnetventile, sein.

Das Sicherheitsschaltgerät 100 ist vorliegend so ausgebildet, dass es ausgangsseitig mindestens zwei externe Schaltelemente - also elektrische Lasten im oben genannten Sinne - ansteuern kann. Die externen Schaltelemente sind in diesem Ausführungsbeispiel als Schütze 103, 104 ausgebildet. Die Schütze 103, 104 weisen jeweils eine Anzahl von Schaltkontakten 105, 106 auf, die vorzugsweise zwangsgeführt ausgebildet sind. Das bedeutet, dass die Schaltkontakte 105, 106 jedes einzelnen Schützes 103, 104 mechanisch derart miteinander gekoppelt sind, dass sie zwangsweise jeweils dieselbe Schaltstellung (geöffnet oder geschlossen) einnehmen. In dem hier dargestellten Ausführungsbeispiel sind die Schaltkontakte 105 des ersten Schützes 103 in Reihe zu den Schaltkontakten 106 des zweiten Schützes 104 in einem Stromversorgungspfad 107 des Roboters 102 angeordnet.

Das Sicherheitsschaltgerät 100 ist eingangsseitig mit zumindest einem Signalgeber 108 verbunden, der bei dem in Fig. 1 gezeigten Ausführungsbeispiel als Schutztürschalter ausgebildet ist. Der Schutztürschalter 108 wirkt mit einem Betätigungsmittel 109 zusammen, welches an einer Schutztür 110 angebracht ist. Wenn die Schutztür 110 geschlossen ist, befindet sich das Betätigungsmittel 109 in einem räumlichen Nahbereich des Schutztürschalters 108. Dieses kann der Schutztürschalter 108 zum Beispiel durch eine induktive, kapazitive, magnetische, mechanische oder anderweitige Kopplung detektieren. Der Schutztürschalter 108 liefert dann ein entsprechendes Eingangssignal 111 an das Sicherheitsschaltgerät 100, welches den Zustand der geschlossenen Schutztür 110 repräsentiert.

Wenn die Schutztür 110 hingegen geöffnet ist, befindet sich das Betätigungsmittel 109 nicht mehr im Nahbereich des Schutztürschalters 108, der daraufhin ein Eingangssignal 111 erzeugt, das aufgrund der nunmehr geöffneten Schutztür 110 eine Sicherheitsanforderung repräsentiert. Sobald das Sicherheitsschaltgerät 100 diese Sicherheitsanforderung erkennt oder wenn aufgrund eines internen Funktionstests ein Gerätefehler erfasst wird, schaltet das Sicherheitsschaltgerät 100 mithilfe seines mehrkanaligen Abschaltsignals 112, 113 die beiden Schütze 103, 104 ab. Daraus resultiert, dass die Schaltkontakte 105, 106 im Stromversorgungspfad 107 des Roboters 102 abfallen und geöffnet werden. Der Roboter 102 wird dadurch abgeschaltet.

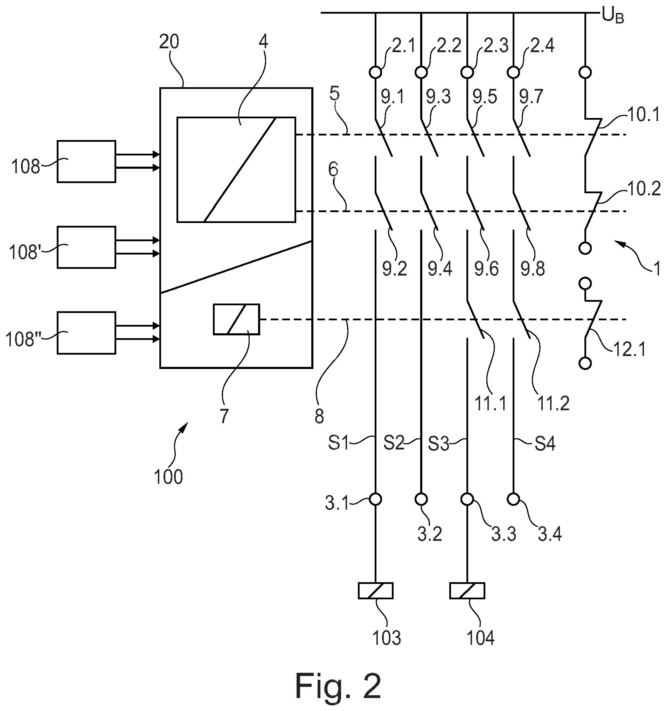

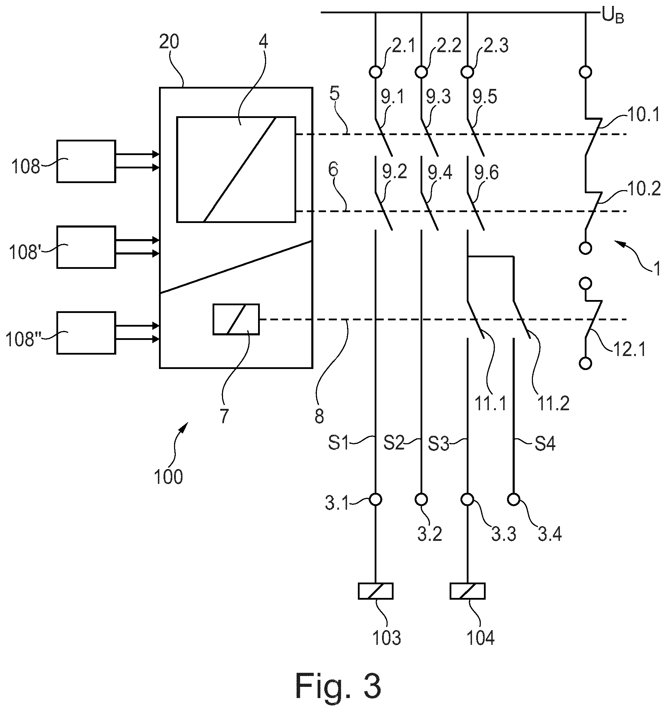

Das Sicherheitsschaltgerät 100 ist vorliegend relaisbasiert ausgebildet und weist kontaktbehaftete, potentialfreie Ausgänge auf. Fig. 2 und 3 zeigen zwei Ausführungsbeispiele des Sicherheitsschaltgeräts 100. Eine zentrale Baugruppe der beiden Sicherheitsschaltgeräte 100 ist jeweils eine Relaisvorrichtung 1, die in den beiden Ausführungsbeispielen unterschiedlich ausgeführt ist.

Unter Bezugnahme auf Fig. 2 umfasst das Sicherheitsschaltgerät 100 eine Relaisvorrichtung 1 und eine Auswerte- und Steuereinrichtung 20, die dazu ausgebildet ist, ein oder mehrere Eingangssignale von Signalgebern 108, 108', 108", die an das Sicherheitsschaltgerät 100 angeschlossen sind, zu empfangen und auszuwerten und die Relaisvorrichtung 1 anzusteuern.

Über den in Fig. 1 exemplarisch dargestellten Schutztürschalter 108 hinaus können die Signalgeber 108, 108', 108" zum Beispiel Not-Aus-Taster 108', Lichtschranken oder Lichtgitter 108'', Zwei-Hand-Taster, Zustimm-Taster oder auch Signale von Überwachungsgeräten für Drehzahl, Spannung, Strom oder dergleichen sein. Das oder die Eingangssignale werden der Auswerte- und Steuereinrichtung 20 zugeführt, die vorzugsweise mehrkanalig-redundant ausgebildet ist, um die Fehlersicherheit zu erhöhen. Dieses wurde in Fig. 2 mittels der diagonalen Trennlinie der Auswerte- und Steuereinrichtung 20 symbolisiert. Die Auswerte- und Steuereinrichtung 20 kann zum Beispiel eine Schaltung sein, die aus diskreten Bauelementen aufgebaut ist. Alternativ kann die Auswerte- und Steuereinheit 20 auch mithilfe von Mikrocontrollern und/oder anderen hochintegrierten Bauelementen realisiert sein.

Die Relaisvorrichtung 1 des Sicherheitsschaltgeräts 100 gemäß Fig. 2 umfasst in diesem Ausführungsbeispiel insgesamt vier Eingangsanschlüsse 2.1-2.4 und vier Ausgangsanschlüsse 3.1-3.4, so dass insgesamt vier parallele Schaltpfade S1-S4 zur Verfügung gestellt werden. Die Relaisvorrichtung 1 umfasst ferner ein erstes ausgangsseitiges Relais 4, welches als Doppelankerrelais mit zwei Ankern 5, 6 ausgebildet ist, sowie ein zweites ausgangsseitiges Relais 7, welches einen Anker 8 aufweist. Die Schaltstellungen der beiden Relais 4, 7 werden von der Auswerte- und Steuereinrichtung 20 bestimmt.

Jedes der beiden Relais 4, 7 weist eine Anzahl zwangsgeführter Schließerkontakte 9.1-9.8, 11.1, 11.2 und Öffnerkontakte 10.1, 10.2, 12.1 auf. In den vier Schaltpfaden S1-S4 sind einige der Schließerkontakte 9.1-9.8 des ersten Relais 4 und die Schließerkontakte 11.1, 11.2 des zweiten Relais 4, 7 in der weiter unten noch näher erläuterten Weise elektrisch in Reihe zueinander zwischen den Eingangsanschlüssen 2.1-2.4 und den Ausgangsanschlüssen 3.1-3.4 angeordnet.

Die Auswerte- und Steuereinheit 20 ist vorliegend so ausgebildet, dass sie die Relais 4, 7 zumindest beim Abschalten der durch die Schütze 103, 104 gebildeten elektrischen Lasten zeitlich versetzt zueinander ansteuern kann, so dass eine Ausschaltverzögerung zur Verfügung gestellt wird. Bevorzugt erfolgt auch das Wiedereinschalten der Schütze 103, 104 zeitlich versetzt zueinander, so dass auch eine Einschaltverzögerung zur Verfügung gestellt wird.

Das erste Relais 4 weist in diesem Ausführungsbeispiel insgesamt acht zwangsgeführte Schließerkontakte 9.1-9.8 sowie zwei zwangsgeführte Öffnerkontakte 10.1, 10.2 auf. Wie in der Darstellung gemäß Fig. 2 zu erkennen, sind die Schließerkontakte 9.1-9.8 jeweils paarweise elektrisch in Reihe angeordnet. Die beiden Öffnerkontakte 10.1, 10.2 sind ebenfalls elektrisch in Reihe angeordnet. Auf diese Weise ergibt sich durch jedes der Schließerkontaktpaare in jedem der vier Schaltpfade S1-S4 eine unter Sicherheitsaspekten besonders vorteilhafte Redundanz der betreffenden Schließerkontakte 9.1-9.8 des ersten Relais 4.

Die Bewegung der beiden Anker 5, 6 des ersten Relais 4 kann mittels einer gemeinsamen, hier nicht explizit dargestellten Relaisspule initiiert werden. In einigen Anwendungen kann auch jedem der beiden Anker 5, 6 eine eigene Relaisspule zugeordnet sein.

Der erste Anker 5 schiebt eine erste Schließerkontaktgruppe, welche in dem hier gezeigten Ausführungsbeispiel aus den Schließerkontakten 9.1, 9.3, 9.5, 9.7 sowie dem Öffnerkontakt 10.1 besteht. Der zweite Anker 6 schiebt eine zweite Schließerkontaktgruppe, welche in dem hier gezeigten Ausführungsbeispiel aus den Schließerkontakten 9.2, 9.4, 9.6, 9.8 sowie dem Öffnerkontakt 10.2 besteht.

Das zweite Relais 7, das elektrisch in Reihe zum ersten Relais 4 angeordnet ist, weist zwei zwangsgeführte Schließerkontakte 11.1, 11.2 sowie einen Öffnerkontakt 12.1 auf, die von einem Anker 8 geschoben werden. Die Bewegung des Ankers 8 des zweiten Relais 7 wird von einer Relaisspule initiiert, die ebenfalls nicht explizit dargestellt ist.

Wie oben bereits erwähnt, stellt die Relaisvorrichtung 1 in diesem Ausführungsbeispiel insgesamt vier parallele Schaltpfade S1-S4 zur Verfügung.

Ein erster Schaltpfad S1 wird durch den ersten Eingangsanschluss 2.1, die beiden elektrisch in Reihe angeordneten Schließerkontakte 9.1, 9.2 des ersten Relais 4 und den ersten Ausgangsanschluss 3.1 gebildet. Ein zweiter Schaltpfad S2 wird durch den zweiten Eingangsanschluss 3.2, die beiden elektrisch in Reihe angeordneten Schließerkontakte 9.3, 9.4 des ersten Relais 4 und den zweiten Ausgangsanschluss 3.2 gebildet. Ein dritter Schaltpfad S3 wird durch den dritten Eingangsanschluss 2.3, die beiden elektrisch in Reihe angeordneten Schließerkontakte 9.5, 9.6 des ersten Relais 4, den Schließerkontakt 11.1 des zweiten Relais 7 und den dritten Ausgangsanschluss 3.3 gebildet. Ein vierter Schaltpfad S4 wird durch den vierten Eingangsanschluss 2.4, die beiden elektrisch in Reihe angeordneten Schließerkontakte 9.7, 9.8 des ersten Relais 4, den Schließerkontakt 11.2 des zweiten Relais 7 und den vierten Ausgangsanschluss 3.4 gebildet.

An die Eingangsanschlüsse 2.1-2.4 der Relaisvorrichtung 1 wird eine Betriebsspannung U_{B}, die für den Betrieb der beiden Schütze 103, 104 erforderlich ist, angelegt. Beispielsweise kann an die Eingangsanschlüsse 2.1-2.4 eine Betriebsspannung U_{B} = 24 V angelegt werden. Ausgangsseitig ist vorliegend das erste Schütz 103 an den ersten Ausgangsanschluss 3.1 und somit an den ersten Schaltpfad S1 der Relaisvorrichtung 1 des Sicherheitsschaltgeräts 100 angeschlossen. Das zweite Schütz 104 ist an den dritten Ausgangsanschluss 3.3 und somit an den dritten Schaltpfad S3 der Relaisvorrichtung 1 angeschlossen.

Aufgrund der Möglichkeit der zeitlich versetzten Ansteuerung der beiden Relais 4, 7 und wegen der getrennten Herausführung der entsprechenden Ausgangsanschlüsse 3.1, 3.3, an denen die Schütze 103, 104 in diesem Ausführungsbeispiel angeschlossen sind, werden beim Abschalten folglich auch die Schaltkontakte 105, 106 der Schütze 103, 104 zeitlich versetzt zueinander geöffnet.

Die zusätzlich vorgesehenen Öffnerkontakte 10.1, 10.2, 12.1 der beiden Relais 4, 7 ermöglichen in vorteilhafter Weise eine separate Kontrolle der jeweiligen Schaltstellungen der Schließerkontakte 9.1-9.8 des ersten Relais 4 und der Schließerkontakte 11.1, 11.2 des zweiten Relais 7. Denn aufgrund der Zwangsführung werden die Öffnerkontakte 10.1, 10.2, 12.1 der Relais 4, 7 geöffnet, wenn die Schließerkontakte 9.1-9.8, 11.1, 11.2 der betreffenden Relais 4, 7 geschlossen werden, und umgekehrt. Ein Fehler, wie zum Beispiel ein Verkleben eines der Schließerkontakte 9.1-9.8, 11.1, 11.2 der beiden Relais 4, 7 kann dadurch in einfacher Weise erkannt werden, da der zugehörige Öffnerkontakt 10.1, 10.2, 12 seine Schaltstellung nicht ändert. Dieses Verhalten kann zum Beispiel sehr einfach mittels der Auswerte- und Steuereinheit 20 ausgewertet werden, indem die Eingangsanschlüsse und Ausgangsanschlüsse der betreffenden Öffnerkontakte 10.1, 10.2, 12.1 an die Auswerte- und Steuereinheit 20 des Sicherheitsschaltgeräts 100 angeschlossen werden.

Nachfolgend soll das Schaltverhalten des Sicherheitsschaltgeräts 100, das sich unmittelbar auf das Schaltverhalten der daran angeschlossenen Schütze 103, 104 auswirkt, näher erläutert werden. Es soll davon ausgegangen werden, dass die Schutztür 110 der technischen Anlage 100 in einem ersten Zustand geschlossen ist und in einem zweiten Zustand geöffnet ist.

In jedem der beiden Zustände wird vom Signalgeber 108 ein entsprechendes Eingangssignal 111 erzeugt und zum Sicherheitsschaltgerät 100 übertragen. Mittels der Auswerte- und Steuerungseinrichtung 20 wird das Eingangssignal 111 verarbeitet und fehlersicher ausgewertet, so dass die beiden Relais 4, 7 entsprechend angesteuert werden können.

Im ersten Zustand, welcher die geschlossene Schutztür 110 repräsentiert, geht das Eingangssignal 111 in einen ersten (aktiven) Spannungszustand U1 (zum Beispiel U1 > 0 V) über. Wenn nun die Schutztür 110 von einem Benutzer geöffnet wird (zweiter Zustand) und/oder ein Defekt in der Signalkette zwischen dem Sicherheitsschaltgerät 100 und dem Signalgeber 108 vorliegt, geht das Eingangssignal 111 in einen zweiten Spanungszustand U2, der sich vom ersten Spannungszustand U1 unterscheidet (zum Beispiel U2 = 0 V), über.

Das Sicherheitsschaltgerät 100 ist dazu eingerichtet, das Eingangssignal 111 in an sich bekannter Weise mittels der Auswerte- und Steuereinrichtung 20 fehlersicher auszuwerten und in Abhängigkeit davon zwei redundante, zeitlich zueinander versetzte Abschaltsignale 112, 113 für die Schütze 103, 104 zu erzeugen. Vorliegend wird dabei das erste Abschaltsignal 112 für das erste Schütz 103 zeitlich versetzt zum Abschaltsignal 113 für das zweite Schütz 104 aktiviert. Umgekehrt werden auch beim Einschaltvorgang die entsprechenden Einschaltsignale 112', 113' für die Schütze 103, 104 zeitlich versetzt zueinander aktiviert. Dieses soll nachfolgend näher erläutert werden.

Für eine Einschaltverzögerung wird zunächst das erste Relais 4, welches als Doppelankerrelais ausgebildet ist, aktiviert. Das bedeutet, dass die zwangsgeführten Schließerkontakte 9.1-9.8 des ersten Relais 4 mittels des ersten Ankers 5 und des zweiten Ankers 6 in die Schließstellung überführt werden. Daraus folgt, dass der erste Schaltpfad S1 und der zweite Schaltpfad S2 geschlossen werden, wohingegen der dritte Schaltpfad S3 und der vierte Schaltpfad S4 weiterhin geöffnet bleiben. Dadurch wird ein Einschaltsignal 112' (U = U_{B}) für das an den ersten Schaltpfad S1 angeschlossene erste Schütz 103 erzeugt. Das erste Schütz 103 wird mit der Betriebsspannung U_{B} versorgt, so dass die zugehörigen Schaltkontakte 105 geschlossen werden.

Nach Ablauf einer voreingestellten oder voreinstellbaren Einschaltverzögerungszeit wird das zweite Relais 7 aktiviert. Das bedeutet, dass die zwangsgeführten Schließerkontakte 10.1, 10.2 des zweiten Relais 7 mittels des zugehörigen Ankers 8 in die Schließstellung überführt werden. Daraus folgt, dass dann auch der dritte Schaltpfad S3 und der vierte Schaltpfad S4 geschlossen werden. Dadurch wird ein Einschaltsignal 113' (U = U_{B}) für das an den dritten Schaltpfad S2 angeschlossene zweite Schütz 104 erzeugt. Das zweite Schütz 104 wird mit der Betriebsspannung U_{B} versorgt, so dass die zugehörigen Schaltkontakte 106 ebenfalls geschlossen werden.

Nachdem auf diese Weise alle Schaltkontakte 105, 106 der Schütze 103, 104 im Stromversorgungspfad 107 des Roboters 102 geschlossen worden sind, kann sich dann auch der Roboter 102 in Betrieb setzen, da er mit Strom versorgt wird.

Für die Bereitstellung einer Ausschaltverzögerung wird zunächst das zweite Relais 7 deaktiviert. Die zwangsgeführten Schließerkontakte 10.1, 10.2 des zweiten Relais 7 werden geöffnet. Dadurch werden der dritte Schaltpfad S3 und der vierte Schaltpfad S4 unterbrochen und ein Abschaltsignal 113 (insbesondere U = 0 V) für das zweite Schütz 104 erzeugt, welches bewirkt, dass die zugehörigen Schaltkontakte 106 im Stromversorgungspfad 107 des Roboters 102 geöffnet werden. Dadurch wird die Stromversorgung des Roboters 102 unterbrochen, so dass dieser außer Betrieb gesetzt wird. Nach Ablauf einer voreingestellten oder voreinstellbaren Ausschaltverzögerungszeit werden dann auch die Schließerkontakte 9.1-9.8 des ersten Relais 4 geöffnet. Dadurch werden der erste Schaltpfad S1 und der zweite Schaltpfad S2 unterbrochen und ein Abschaltsignal 112 (insbesondere U = 0 V) für das erste Schütz 103 erzeugt, welches bewirkt, dass die zugehörigen Schaltkontakte 105 im Stromversorgungspfad 107 des Roboters 102 ebenfalls geöffnet werden.

Wenn das zweite Relais 7 bei einem Fehlerfall, insbesondere bei einem Verkleben eines der Schließerkontakte 11.1, 11.2, nicht mehr schalten kann, wird dieses mittels des Öffnerkontakts 12.1 des zweiten Relais 7 erkannt. In vorteilhafter Weise ist das Sicherheitsschaltgerät 100 so ausgebildet, dass beim Auftreten eines derartigen Fehlers das erste Relais 4 abgeschaltet wird.

Unter Bezugnahme auf Fig. 3 soll nachfolgend ein zweites Ausführungsbeispiel eines Sicherheitsschaltgeräts 100 mit einer Relaisvorrichtung 1 näher erläutert werden. Der grundlegende Aufbau und die Funktionsweise entsprechen demjenigen des ersten Ausführungsbeispiels, so dass nachfolgend nur die Unterschiede erläutert werden sollen.

In diesem Ausführungsbeispiel umfasst die Relaisvorrichtung 1 des Sicherheitsschaltgeräts 100 insgesamt drei Eingangsanschlüsse 2.1-2.3 und vier Ausgangsanschlüsse 3.1-3.4. Wie in Fig. 3 zu erkennen, teilen sich die beiden parallelen Schließerkontakte 11.1, 11.2 des zweiten Relais 7 die beiden elektrisch in Reihe zueinander angeordneten Schließerkontakte 9.5 und 9.6 und damit auch den dritten Eingangsanschluss 2.3 des ersten, wiederum als Doppelankerrelais ausgebildeten Relais 4. Da die beiden Schließerkontakte 11.1, 11.2 des zweiten Relais 7 eine Parallelschaltung bilden, ergeben sich wiederum insgesamt vier parallele Schaltpfade S1-S4 zwischen den drei Eingangsanschlüssen 2.1-2.3 und den vier Ausgangsanschlüssen 3.1-3.4. Der dritte Schaltpfad S3 und der vierte Schaltpfad S4 teilen sich den dritten Eingangsanschluss 2.3 als gemeinsame Wurzel.

Durch die Ausführung des ersten Relais 4 in beiden Ausführungsbeispielen als Doppelankerrelais ergeben sich unter anderem Sicherheitsvorteile. Denn alle bewegbaren Teile des als Doppelankerrelais ausgeführten ersten Relais 4 sind doppelt ausgeführt. Durch diese Redundanz wird die Betriebssicherheit des ersten Relais 4 und damit auch des gesamten Sicherheitsschaltgeräts 100 erheblich erhöht. Wäre das erste Relais 4 als "einfaches" Relais mit einem einzigen Schließerkontakt im ersten Schaltpfad S1 und einem einzigen Schließerkontakt im zweiten Schaltpfad S2 ausgeführt, wären der erste Schaltpfad S1 und der zweite Schaltpfad S2 nicht sicher. Darüber hinaus benötigt ein Doppelankerrelais weniger Platz als zwei separate, elektrisch in Reihe angeordnete Relais, mit denen die Schaltfunktionalität des Doppelankerrelais ebenfalls realisiert werden könnte. Der externe Verdrahtungsaufwand ist bei einem Doppelankerrelais geringer, da weniger elektrische Schaltkontakte miteinander zu verdrahten sind. Überdies benötigt ein Doppelankerrelais weniger Bauraum, da die technischen Funktionen zweier elektrisch in Reihe zueinander angeordneter Relais in einem Bauteil realisiert sind. Der Bauraumvorteil wird größer, wenn das erste Relais 4 nur eine einzige Relaisspule für die elektromagnetische Wechselwirkung mit den beiden Ankern 5, 6 aufweist.

Mittels der hier vorgestellten Sicherheitsschaltgeräte 100 wird beim sicherheitsgerichteten Abschalten des Roboters 102 eine zusätzliche Fehlersicherheit dadurch erreicht, dass die redundanten externen Schütze 103, 104 zeitlich versetzt zueinander geöffnet werden. Hierdurch sinkt die Wahrscheinlichkeit, dass die Schütze 103, 104 zeitgleich ausfallen, wodurch die Fehlersicherheit deutlich verbessert wird.

Es soll an dieser Stelle betont werden, dass das Einsatzgebiet der in Fig. 2 und 3 dargestellten Relaisvorrichtungen 1 nicht auf die explizit dargestellten Sicherheitsschaltgeräte 100 beschränkt ist. Die Relaisvorrichtungen 1 können überall dort eingesetzt werden, wo aus technischer Sicht das Erfordernis besteht, Einschaltverzögerungen und/oder Ausschaltverzögerungen für elektrische Lasten oder Verbraucher zur Verfügung zu stellen. Es ist mittels der hier vorgestellten Relaisvorrichtungen 1 auch möglich, zwei verschiedene Teile einer Maschine oder technischen Anlage, die elektrische Lasten beziehungsweise Verbraucher bilden, zeitversetzt zu schalten. Beispielsweise kann zunächst eine Steuerungseinrichtung eingeschaltet werden und zeitlich versetzt dazu ein Roboter aktiviert werden.

## Patentansprüche

1. Relaisvorrichtung (1), umfassend
- eine Anzahl von Eingangsanschlüssen (2.1-2.4),
- eine Anzahl von Ausgangsanschlüssen (3.1-3.4),
- ein erstes Relais (4) mit einer Anzahl n ≥ 2 zwangsgeführter und parallel zueinander angeordneter Schließerkontakte (9.1, 9.3, 9.5, 9.7), die eine erste Schließerkontaktgruppe bilden und mittels eines ersten gemeinsamen Ankers (5) von einer Öffnungsstellung in eine Schließstellung und umgekehrt bewegbar sind,
- ein zweites Relais (7) mit einer Anzahl m < n zwangsgeführter und parallel zueinander angeordneter Schließerkontakte (11.1, 11.2), die mittels eines gemeinsamen Ankers (8) von einer Öffnungsstellung in eine Schließstellung und umgekehrt bewegbar sind,
wobei das erste Relais (4) und das zweite Relais (7) elektrisch in Reihe zueinander zwischen den Eingangsanschlüssen (2.1-2.4) und den Ausgangsanschlüssen (3.1-3.4) angeordnet sind, so dass die Relaisvorrichtung (1) mehrere parallele Schaltpfade (S1-S4) aufweist, und wobei in einer Anzahl von Schaltpfaden (S3, S4), die der Anzahl m der Schließerkontakte (11.1, 11.2) des zweiten Relais (7) entspricht, jeweils ein Schließerkontakt (9.5, 9.7) des ersten Relais (4) und ein Schließerkontakt (11.1, 11.2) des zweiten Relais (7) elektrisch in Reihe angeordnet sind, wobei das erste Relais (4) als Doppelankerrelais ausgebildet ist und eine der Anzahl der Schließerkontakte (9.1, 9.3, 9.5, 9.7) der ersten Schließerkontaktgruppe entsprechende Anzahl zwangsgeführter und parallel zueinander angeordneter Schließerkontakte (9.2, 9.4, 9.6, 9.8) aufweist, die eine zweite Schließerkontaktgruppe bilden und mittels eines zweiten gemeinsamen Ankers (6) von einer Öffnungsstellung in eine Schließstellung und umgekehrt bewegbar sind, wobei die Schließerkontakte (9.1, 9.3, 9.5, 9.7) der ersten Schließerkontaktgruppe und die Schließerkontakte (9.2, 9.4, 9.6, 9.8) der zweiten Schließerkontaktgruppe paarweise elektrisch in Reihe angeordnet sind.

2. Relaisvorrichtung (1) nach Anspruch 1, **dadurch gekennzeichnet, dass** die Relaisvorrichtung (1) eine erste Relaisspule, die mit dem ersten Anker (5) des ersten Relais (4) elektromagnetisch gekoppelt ist, und eine zweite Relaisspule, die mit dem zweiten Anker (6) des ersten Relais (4) elektromagnetisch gekoppelt ist, aufweist.

3. Relaisvorrichtung (1) nach Anspruch 1, **dadurch gekennzeichnet, dass** die Relaisvorrichtung (1) eine Relaisspule, die mit dem ersten Anker (5) des ersten Relais (4) und mit dem zweiten Anker (6) des ersten Relais (4) elektromagnetisch gekoppelt ist, aufweist.

4. Relaisvorrichtung (1) nach einem der Ansprüche 1 bis 3, **dadurch gekennzeichnet, dass** die Relaisvorrichtung (1) eine Anzahl von Eingangsanschlüssen (2.1-2.4) aufweist, die kleiner als die Anzahl der Ausgangsanschlüsse (3.1-3.4) ist.

5. Relaisvorrichtung (1) nach einem der Ansprüche 1 bis 4, **dadurch gekennzeichnet, dass** das erste Relais (4) einen ersten zwangsgeführten Öffnerkontakt (10.1), der dazu ausgebildet ist, die Schaltstellungen der Schließerkontakte (9.1, 9.3, 9.5, 9.7) der ersten Schließerkontaktgruppe des ersten Relais (4) zu erfassen, und einen zweiten zwangsgeführten Öffnerkontakt (10.2), der dazu ausgebildet ist, die Schaltstellungen der Schließerkontakte (9.2, 9.4, 9.6, 9.8) der zweiten Schließerkontaktgruppe zu erfassen, aufweist.

6. Relaisvorrichtung (1) nach Anspruch 5, **dadurch gekennzeichnet, dass** die Öffnerkontakte (10.1, 10.2) des ersten Relais (4) elektrisch in Reihe angeordnet sind.

7. Relaisvorrichung (1) nach einem der Ansprüche 1 bis 6, **dadurch gekennzeichnet, dass** das zweite Relais (7) einen zwangsgeführten Öffnerkontakt (12.1) umfasst, der dazu ausgebildet ist, die Schaltstellungen der Schließerkontakte (11.1, 11.2) des zweiten Relais (7) zu erfassen.

8. Sicherheitsschaltgerät (100) zum fehlersicheren Abschalten einer Mehrzahl elektrischer Lasten oder Verbraucher, umfassend
- eine Auswerte- und Steuereinrichtung (20), die dazu eingerichtet ist, Eingangssignale (111) zumindest eines Signalgebers (108, 108', 108") zu empfangen und fehlersicher auszuwerten,
- zumindest eine Relaisvorrichtung (1) mit einer Mehrzahl von Ausgangsanschlüssen (3.1-3.4) zum Anschluss der elektrischen Lasten oder Verbraucher, die von der Auswerte- und Steuereinrichtung (20) ansteuerbar ist,
**dadurch gekennzeichnet, dass** die Relaisvorrichtung (1) nach einem der Ansprüche 1 bis 7 ausgeführt ist und dass die Auswerte- und Steuereinrichtung (20) dazu eingerichtet ist, das erste Relais (4) und das zweite Relais (7) zeitlich versetzt zueinander anzusteuern.

## Claims

1. Relay device (1), comprising
- a number of input connections (2.1-2.4),
- a number of output connections (3.1-3.4),
- a first relay (4) having a number n ≥ 2 of forcibly guided normally open contacts (9.1, 9.3, 9.5, 9.7) which are arranged in parallel with each other and form a first normally open contact group and can be moved from an open position to a closed position and vice versa by means of a first common armature (5),
- a second relay (7) having a number m < n of forcibly guided normally open contacts (11.1, 11.2) which are arranged in parallel with each other and can be moved from an open position to a closed position and vice versa by means of a common armature (8),
wherein the first relay (4) and the second relay (7) are arranged electrically in series with each other between the input connections (2.1-2.4) and the output connections (3.1-3.4), so that the relay device (1) has a plurality of parallel switching paths (S1-S4), and wherein, in a number of switching paths (S3, S4) which corresponds to the number m of normally open contacts (11.1, 11.2) of the second relay (7), a normally open contact (9.5, 9.7) of the first relay (4) and a normally open contact (11.1, 11.2) of the second relay (7) are arranged electrically in series, wherein the first relay (4) is designed as a double-armature relay and comprises a number of forcibly guided normally open contacts (9.2, 9.4, 9.6, 9.8), arranged in parallel with one another, corresponding to the number of normally open contacts (9.1, 9.3, 9.5, 9.7) of the first normally open contact group and forming a second normally open contact group and being movable by means of a second common armature (6) from an open position to a closed position and vice versa, wherein the normally open contacts (9.1, 9.3, 9.5, 9.7) of the first normally open contact group and the normally open contacts (9.2, 9.4, 9.6, 9.8) of the second normally open contact group are arranged electrically in series in pairs.

2. Relay device (1) according to Claim 1, **characterized in that** the relay device (1) has a first relay coil, which is electromagnetically coupled to the first armature (5) of the first relay (4), and a second relay coil, which is electromagnetically coupled to the second armature (6) of the first relay (4).

3. Relay device (1) according to Claim 1, **characterized in that** the relay device (1) has a relay coil, which is electromagnetically coupled to the first armature (5) of the first relay (4) and to the second armature (6) of the first relay (4).

4. Relay device (1) according to any of Claims 1 to 3, **characterized in that** the relay device (1) has a number of input connections (2.1-2.4) which is less than the number of output connections (3.1-3.4).

5. Relay device (1) according to any of Claims 1 to 4, **characterized in that** the first relay (4) has a first forcibly guided normally closed contact (10.1), which is designed to detect the switching positions of the normally open contacts (9.1, 9.3, 9.5, 9.7) of the first normally open contact group of the first relay (4), and a second forcibly guided normally closed contact (10.2), which is designed to detect the switching positions of the normally open contacts (9.2, 9.4, 9.6, 9.8) of the second normally open contact group.

6. Relay device (1) according to Claim 5, **characterized in that** the normally closed contacts (10.1, 10.2) of the first relay (4) are arranged electrically in series.

7. Relay device (1) according to any of Claims 1 to 6, **characterized in that** the second relay (7) comprises a forcibly guided normally closed contact (12.1), which is designed to detect the switching positions of the normally open contacts (11.1, 11.2) of the second relay (7).

8. Safety switching device (100) for the fail-safe shutdown of a plurality of electrical loads or electrical power consumers, comprising
- an evaluation and control device (20), which is configured to receive input signals (111) of at least one signal transmitter (108, 108', 108'') and evaluate them in a fail-safe manner,
- at least one relay device (1) having a plurality of output connections (3.1-3.4) for connecting the electrical loads or electrical power consumers, which relay device can be controlled by the evaluation and control device (20),
**characterized in that** the relay device (1) is designed according to any of Claims 1 to 7 and **in that** the evaluation and control device (20) is configured to control the first relay (4) and the second relay (7) with a time offset in relation to each other.

## Revendications

1. Dispositif relais (1), comprenant
- un certain nombre de bornes d'entrée (2.1-2.4),
- un certain nombre de bornes de sortie (3.1-3.4),
- un premier relais (4) comportant un nombre n ≥ 2 de contacts de fermeture (9.1, 9.3, 9.5, 9.7) à guidage forcé et disposés parallèlement les uns aux autres, lesquels forment un premier groupe de contacts de fermeture et peuvent être déplacés d'une position d'ouverture à une position de fermeture et inversement au moyen d'une première armature commune (5),
- un second relais (7) comportant un nombre m < n de contacts de fermeture (11.1, 11.2) à guidage forcé et disposés parallèlement les uns aux autres, lesquels peuvent être déplacés d'une position d'ouverture à une position de fermeture et inversement au moyen d'une armature commune (8),
le premier relais (4) et le second relais (7) étant disposés électriquement en série entre les bornes d'entrée (2.1-2.4) et les bornes de sortie (3.1-3.4), de sorte que le dispositif relais (1) présente plusieurs trajets de commutation parallèles (S1-S4), et dans un certain nombre de trajets de commutation (S3, S4) correspondant au nombre m des contacts de fermeture (11.1, 11.2) du second relais (7), respectivement un contact de fermeture (9.5, 9.7) du premier relais (4) et un contact de fermeture (11.1, 11.2) du second relais (7) étant disposés électriquement en série, le premier relais (4) étant conçu comme un relais à double armature et présentant un nombre de contacts de fermeture (9.2, 9.4, 9.6, 9.8) à guidage forcé, disposés parallèlement les uns aux autres, qui correspond au nombre des contacts de fermeture (9.1, 9.3. 9.5, 9.7) du premier groupe de contacts de fermeture, lesquels forment un second groupe de contacts de fermeture et peuvent être déplacés d'une position d'ouverture à une position de fermeture et inversement au moyen d'une seconde armature commune (6), les contacts de fermeture (9.1, 9.3, 9.5, 9.7) du premier groupe de contacts de fermeture et les contacts de fermeture (9.2, 9.4, 9.6, 9.8) du second groupe de contacts de fermeture étant disposés électriquement en série par paires.

2. Dispositif relais (1) selon la revendication 1, **caractérisé en ce que** le dispositif relais (1) présente une première bobine de relais qui est couplée électromagnétiquement à la première armature (5) du premier relais (4), et une seconde bobine de relais qui est couplée électromagnétiquement à la seconde armature (6) du premier relais (4).

3. Dispositif relais (1) selon la revendication 1, **caractérisé en ce que** le dispositif relais (1) présente une bobine de relais qui est couplée électromagnétiquement à la première armature (5) du premier relais (4) et à la seconde armature (6) du premier relais (4).

4. Dispositif relais (1) selon l'une quelconque des revendications 1 à 3, **caractérisé en ce que** le dispositif relais (1) présente un nombre de bornes d'entrée (2.1-2.4) qui est inférieur au nombre des bornes de sortie (3.1-3.4).

5. Dispositif relais (1) selon l'une quelconque des revendications 1 à 4, **caractérisé en ce que** le premier relais (4) présente un premier contact d'ouverture (10.1) à guidage forcé, qui est conçu pour détecter les positions de commutation des contacts de fermeture (9.1, 9.3, 9.5, 9.7) du premier groupe de contacts de fermeture du premier relais (4), et un second contact d'ouverture (10.2) à guidage forcé, qui est conçu pour détecter les positions de commutation des contacts de fermeture (9.2, 9.4, 9.6, 9.8) du second groupe de contacts de fermeture.

6. Dispositif relais (1) selon la revendication 5, **caractérisé en ce que** les contacts d'ouverture (10.1, 10.2) du premier relais (4) sont disposés électriquement en série.

7. Dispositif relais (1) selon l'une quelconque des revendications 1 à 6, **caractérisé en ce que** le second relais (7) comprend un contact d'ouverture (12.1) à guidage forcé, qui est conçu pour détecter les positions de commutation des contacts de fermeture (11.1, 11.2) du second relais (7).

8. Appareil de commutation de sécurité (100) pour la coupure de sécurité d'une pluralité de charges électriques ou de consommateurs, comprenant
- un dispositif d'évaluation et de commande (20) qui est conçu pour recevoir des signaux d'entrée (111) d'au moins un émetteur de signaux (108, 108', 108") et pour les évaluer par sécurité intégrée,
- au moins un dispositif relais (1) comportant une pluralité de bornes de sortie (3.1-3.4) pour le raccordement des charges électriques ou des consommateurs, lequel peut être commandé par le dispositif d'évaluation et de commande (20),
**caractérisé en ce que** le dispositif relais (1) est réalisé selon l'une quelconque des revendications 1 à 7, et **en ce que** le dispositif d'évaluation et de commande (20) est conçu pour commander le premier relais (4) et le second relais (7) de manière décalée dans le temps l'un par rapport à l'autre.
